# EUROPÄISCHE PATENTSCHRIFT

(11) **EP 1 325 558 B1**
(45) Veröffentlichungstag und Bekanntmachung des Hinweises auf die Patenterteilung: **05.04.2006**
(21) Anmeldenummer: 01978171.5
(22) Anmeldetag: 20.09.2001
(51) Int. Cl.: H03J 3/08, H03J 3/28

(54) **RESONATORANORDNUNG**
RESONATOR CONFIGURATION
SYSTEME DE RESONATEURS

(30) Priorität: 25.09.2000 DE 10047343
(43) Veröffentlichungstag der Anmeldung: 09.07.2003
(73) Patentinhaber: SIEMENS AKTIENGESELLSCHAFT, 80333 München (DE)
(72) Erfinder: OSTERTAG, Thomas, 85464 Finsing (DE); KORDEN, Christian, 81247 München (DE); RUILE, Werner, 80636 München (DE)
(86) Internationale Anmeldenummer: PCT/DE2001/003642
(87) Internationale Veröffentlichungsnummer: WO 2002/025813

(56) Entgegenhaltungen:
- WO-A-00/28664
- US-A- 4 736 456
- US-A- 5 428 829
- US-A- 5 678 211

## Beschreibung

Die Erfindung betrifft eine Resonatoranordnung und ein Verfahren zur Resonatorabstimmung.

Resonatoren unterliegen in der Herstellung gewissen Fertigungsschwankungen. Weiterhin treten im Betrieb Alterungs- und Temperaturschwankungen auf. Dies führt dazu, dass die Frequenzlage eines in einer Schaltung verwendeten Schaltungsresonators in der Regel nicht exakt den Fertigungsvorgaben entspricht und sich auch im Laufe der Zeit verändern kann.

Gerade bei modernen Telekommunikationseinrichtungen, wie zum Beispiel Mobiltelefonen und anderen mobilen Endgeräten, ist es aber von entscheidender Bedeutung, dass Schaltungsresonatoren mit einer möglichst exakt vorgegebenen Frequenzlage verwendet werden. Dies gilt um so mehr für modern werdende Direct-Conversion-Verfahren, die nur mit äußerst präzise arbeitenden Filtern realisiert werden können.

Für Filter in dem genannten Einsatzbereich wurden bislang Resonatoren in Form von Oberflächenwellenbauelementen eingesetzt. Solche Oberflächenwellenbauelemente sind zum Beispiel aus DE 198 60 058 C1, EP 0 746 775 B1, EP 0 655 701 B1, EP 0 651 344 B1, EP 0 619 906 B1, US 5 691 698, US 5 841 214, US 5 966 008, US 5 910 779, US 6 029 324 und US 6 084 503 bekannt. Sie zeichnen sind insbesondere durch eine hohe Langzeitstabilität aus.

Leider sind diese Oberflächenwellenbauelemente nicht in die Halbleitertechnik integrierbar, weshalb Hybridlösungen verfolgt werden müssen. Um von diesen Hybridlösungen wegzukommen sind FBARs (Film Bulk Acoustic Resonators) bekannt, die zumindest teilweise CMOS-kompatibel hergestellt werden können. Allerdings lässt sich hier die erforderliche Frequenzgenauigkeit herstellungstechnisch nicht beherrschen, so dass eine Massenfertigung und damit niedrige Preise nicht verfügbar sind.

In US 5,428,829 werden aktive Filter beschrieben, die in Halbleitertechnologie, insbesondere in CMOS-Technologie integriert sind. Eine aktive Filterschaltung wird durch bestimmte Einstellungen von Verstärkung und Phasenlage zum Schwingen angeregt und als Oszillator in einer PLL verwendet. Güte und Mittenfrequenz können durch elektrisch abstimmbare Widerstände und Kondensatoren, die als externe Beschaltung in CMOS realisiert sind, geregelt werden.

Davon ausgehend liegt der Erfindung die Aufgabe zugrunde, eine Resonatoranordnung und ein Verfahren zur Resonatorabstimmung vorzuschlagen, durch das sich Herstellungs-, Temperatur- und Alterungsschwankungen der Resonatoren ausgleichen lassen. Weiterhin sollen die Resonatoranordnung und das Verfahren zur Resonatorabstimmung insbesondere für mikrostrukturierte und integrierte Bauelemente geeignet sein.

Diese Aufgabe wird durch eine Resonatoranordnung und ein Verfahren zur Resonatorabstimmung mit den Merkmalen der unabhängigen Ansprüche gelöst.

Die Erfindung geht zunächst von der Erkenntnis aus, statt Resonatoren mit festgelegten Eigenschaften, insbesondere vorgegebener Frequenzlage, abstimmbare Resonatoren zu verwenden. Diese scheinen zwar zur Lösung der vorgegebenen Aufgabe dem ersten Anschein nach weniger geeignet, weil sie in aller Regel noch größeren Herstellungs-, Temperatur- und Alterungsschwankungen unterliegen. Durch die erfindungsgemäße Resonatoranordnung bzw. das Verfahren zur Resonatorabstimmung kann dieser scheinbare Nachteil jedoch kompensiert werden.

Gemäß der Resonatoranordnung wird neben dem eigentlichen Schaltungsresonator noch ein Referenzresonator eingesetzt. Sowohl Referenzresonator als auch Schaltungsresonator sind abstimmbar. Dabei wird von dem Gedanken ausgegangen, dass der Referenzresonator und der Schaltungsresonator in etwa den gleichen Herstellungs-, Temperatur- und Alterungsschwankungen unterliegen. Der Referenzresonator wird über eine Regelgröße so abgestimmt, dass sein Resonatorwert einem vorgegebenen Referenzwert entspricht. Als Resonatorwert bzw. vorgegebener Referenzwert kommt insbesondere eine Frequenzlage in Betracht.

Danach wird der Schaltungsresonator abgestimmt, wobei die Regelgröße für den Referenzresonator als Maß für das Abstimmen des Schaltungsresonators angewendet wird.

Die Resonatoranordnung wird mit mikrostrukturierten und/oder integrierten Bauelementen ausgeführt. Der Referenzresonator und der Schaltungsresonator werden als Oberflächenwellenbauelemente (OFW-Bauelement), als Volumenwellenbauelemente (FBAR) oder als Membranschwinger (MEMS) ausgeführt, wobei diese in hinreichender Weise abstimmbar sind.

Gemäß dem Grundgedanken, dass Referenzresonator und Schaltungsresonator in etwa den gleichen Herstellungs-, Temperatur- und Alterungsschwankungen unterliegen sollen, werden diese vom gleichen Wafer hergestellt. Hierbei müssen der Referenzresonator und der Schaltungsresonator nach der Herstellung noch nicht einmal voneinander getrennt werden, da gerade hierdurch eine besonders gute thermische Verbindung zwischen den Resonatoren gewährleistet wird. Auch sonst ist es vorteilhaft, wenn die Resonatoranordnung Mittel aufweist, um den Referenzresonator und den Schaltungsresonator thermisch miteinander zu verbinden. Um die Verbindungswege möglichst kurz und den Temperaturunterschied zwischen dem Referenzresonator und dem Schaltungsresonator möglichst klein zu halten, sind der Referenzresonator und der Schaltungsresonator benachbart anzuordnen.
Besonders gut lässt sich die Erfindung mit einer Oszillatorschaltung realisieren. Um die Herstellungs-, Temperatur- und Alterungsschwankungen zu kompensieren, wird der Referenzresonator in einer Oszillatorschaltung angeordnet, in der er ein die Oszillatorschaltungsfrequenz bestimmendes Element ist. Stimmt die Oszillatorschaltungsfrequenz mit einer vorgegebenen Referenzfrequenz überein, so kann man deshalb sicher sein, dass der Referenzresonator die gewünschten elektrischen Werte aufweist.

Damit die Oszillatorschaltungsfrequenz in etwa mit der Referenzfrequenz übereinstimmt, wird der Referenzresonator durch Mittel zum Abstimmen des Referenzresonators mittels einer Regelgröße für den Referenzresonator entsprechend abgestimmt. Die Regelgröße für den Referenzresonator wird nun als Maß für das Abstimmen des Schaltungsresonators angewendet. Der Schaltungsresonator ist damit in Abhängigkeit von der Regelgröße für den Referenzresonator abstimmbar.

Sind Referenzresonator und Schaltungsresonator identisch und sollen sie die gleichen elektrischen Werte annehmen, so entspricht im einfachsten Fall die Regelgröße für den Referenzresonator der Regelgröße für den Schaltungsresonator, mit der dieser dann auf die elektrischen Werte des Referenzresonators abgestimmt wird. Es sind aber auch kompliziertere. Zusammenhänge denkbar, etwa wenn Referenzresonator und Schaltungsresonator absichtlich gegeneinander verstimmt werden sollen oder die Mittel zum Abstimmen des Referenzresonators anders ausgebildet sind als die Mittel zum Abstimmen des Schaltungsresonators. Wesentlich ist vielmehr der Gedanke, das Abstimmverhalten des Referenzresonators und insbesondere die dafür verwendete Regelgröße für den Referenzresonator als Informationsquelle zu benutzen, um den Schaltungsresonator auf die gewünschten elektrischen Werte einzustellen. Der Schaltungsresonator bleibt dabei frei von Mitteln, die seine elektrischen Werte messen und kann deshalb unabhängig in beliebigen Schaltungen verwendet werden.

Das korrekte Abstimmen des Referenzresonators lässt sich insbesondere dadurch realisieren, dass der Referenzresonator in einer Oszillatorschaltung angeordnet ist und die Resonatoranordnung Mittel zum Vergleichen der Oszillatorschaltungsfrequenz mit einer Referenzfrequenz aufweist. Für den Referenzwert des Referenzresonators ergibt sich für die Oszillatorschaltungsfrequenz eine Referenzfrequenz. Wird nun der abstimmbare Referenzresonator mit den Mitteln zum Abstimmen des Referenzresonators so abgestimmt, dass die Oszillatorschaltungsfrequenz in etwa der Referenzfrequenz entspricht, so ist der Resonatorwert des abstimmbaren Referenzresonators in etwa gleich dem vorgegebenen Referenzwert.

Ist der Schaltungsresonator in einer Filterschaltung angeordnet, so lässt sich die Resonatoranordnung für alle erdenklichen Filterzwecke einsetzen. Die Resonatoranordnung kann dazu in einem mobilen Endgerät, insbesondere einem Mobiltelefon, angeordnet sein.

Es ist auch möglich, mehrere Referenzresonatoren und/oder Schaltungsresonatoren in der Resonatoranordnung zu verwenden, wobei jedem Schaltungsresonator ein eigener Referenzresonator zugeordnet sein kann oder auch mehrere Schaltungsresonatoren zu demselben Referenzresonator gehören.

Weist die Resonatoranordnung einen zweiten abstimmbaren Schaltungsresonator auf, so lassen sich der Schaltungsresonator und der zweite Schaltungsresonator in einem Laddertype-Filter anordnen, in dem einer der Schaltungsresonatoren mit dem Nutzsignal in Serie geschaltet wird, während der andere in Parallelschaltung dazu geerdet wird. Durch diese Anordnung lässt sich auch mit Eintorschaltungsresonatoren ein Bandpassfilter realisieren. Bei Bedarf kann der zweite Schaltungsresonator gegenüber dem Schaltungsresonator verstimmt sein.

Probleme können sich aus dem Übersprechen der Oszillatorschaltung auf den Schaltungsresonator und die ihm zugeordnete Schaltung ergeben. Um diese Probleme zu vermeiden, kann die Oszillatorschaltung zeitlich diskontinuierlich betrieben werden, wobei die Oszillatorschaltung abgeschaltet wird, sobald die Schaltung, in der der Schaltungsresonator angeordnet ist, aktiv wird.

Alternativ kann ein Übersprechen verhindert werden, indem die Oszillatorschaltungsfrequenz außerhalb der Nutzbandbreite der Filterschaltung liegt, in der der Schaltungsresonator angeordnet ist.

Wenn die Resonatoranordnung Einstellmittel zum Einstellen und/oder Erzeugen eines Schaltungsfrequenzsignals aufweist, das mit dem Ausgangssignal der Filterschaltung gemischt wird, können schließlich als dritte Alternative die Einstellmittel so ausgebildet werden, dass durch die Einstellmittel auch die Oszillatorschaltungsfrequenz einstellbar ist. Insbesondere kann dazu die Oszillatorschaltung einen Oszillator aufweisen, der so ausgebildet ist, dass er auch als Oszillator für die Schaltung dient, in der das Schaltungsfrequenzsignal erzeugt wird. Diese Alternative lässt sich insbesondere im Zusammenhang mit dem Direct-Conversion-Verfahren einsetzen. Ein großer Vorteil bei diesem Betriebsmodus ist, dass keine zusätzlichen Bauteile benötigt werden.

Die genannten Merkmale lassen sich sowohl im Zusammenhang mit der Resonatoranordnung als auch mit dem Verfahren zur Resonatorabstimmung vorteilhaft einsetzen.

Weitere wesentliche Merkmale und Vorteile der Erfindung ergeben sich aus der Beschreibung eines Ausführungsbeispiels anhand der Zeichnung. Dabei zeigt

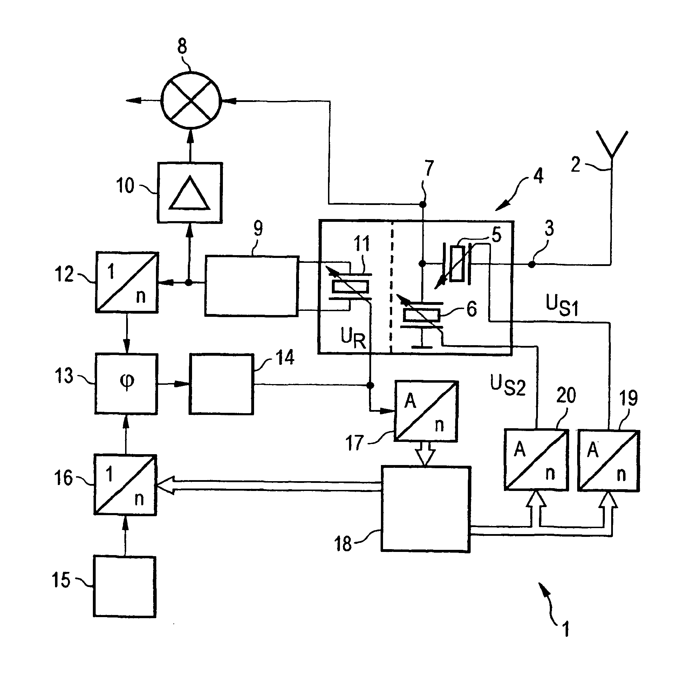

Figur 1 eine Resonatoranordnung.

In Figur 1 erkennt man eine Resonatoranordnung 1 mit einer Antenne 2, über die ein Hochfrequenzsignal empfangen und zum Eingang 3 der Resonatoranordnung 1 geführt wird. Das Hochfrequenzsignal ist insbesondere ein Mobilfunksignal nach GSM- oder UMTS-Standard, ein Signal nach dem Bluetooth-Standard oder ein anderes digitales oder analoges Signal, das zur Übertragung von Informationen dient.

Am Eingang 3 der Resonatoranordnung ist ein Filter 4 angeordnet, das einen abstimmbaren Schaltungsresonator 5 und einen zweiten abstimmbaren Schaltungsresonator 6 enthält. Das Filter 4 ist als Laddertype-Filter aufgebaut, in dem der Schaltungsresonator 5 im Hochfrequenzsignalweg in Serie geschaltet ist, während der zweite Schaltungsresonator 6 in Parallelschaltung zum Signalweg geerdet ist. Das gefilterte Hochfrequenzsignal verlässt das Filter als Ausgangssignal der Filterschaltung am Filterausgang 7 und wird in einem Mischer 8 mit einem von einem Oszillator 9 erzeugten Oszillatorsignal zu einem Zwischenfrequenzsignal gemischt. Bevor das Oszillatorsignal vom Oszillator 9 den Mischer 8 erreicht, durchläuft es einen Pufferverstärker 10.

Der Oszillator 9 ist als spannungskontrollierter Oszillator (Voltage Control Oszillator, VCO) ausgeführt. Er ist mit einem Referenzresonator 11 in einer Oszillatorschaltung angeordnet. Der Referenzresonator 11 ist in eine Phasenregelschleife (PLL) eingebunden. Dazu wird das Oszillatorschaltungssignal über einen programmierbaren Teiler 12 einem Phasenkomparator 13 zugeführt. Über einen Vergleichsfrequenzerzeuger 15, der insbesondere als stabilisierter Volumenschwinger, bevorzugt als Quarz, ausgeführt ist, und einen programmierbaren Teiler 16 wird eine Vergleichsfrequenz auf den Phasenkomparator 13 gegeben, an dessen Ausgang die vom Tiefpass 14 gefilterte Regelgröße U_{R} für den Referenzresonator 11 zur Verfügung steht. Damit wird gewährleistet, dass der Referenzresonator 11 seinen vorgegebenen Referenzwert aufweist.

Das Oszillatorschaltüngsstgnäl wird über einen A/D-Wandler 17 einem Mikrokontroller 18 zugeführt. Die Regelgröße U_{R} für den Referenzresonator 11 wird vom Mikrokontroller 18 als Maß für die Abstimmung des abstimmbaren Schaltungsresonators 5 angewandt. Dazu wird in Abhängigkeit der Regelgröße U_{R} für den Referenzresonator 11 eine Regelgröße U_{S1} für den abstimmbaren Schaltungsresonator 5 errechnet, die nach Vorgabe durch den Mikrokontroller 18 vom D/A-Wandler 19 umgesetzt und auf den abstimmbaren Schaltungsresonator 5 angewandt wird.

In analoger Weise wird eine Regelgröße U_{S2} für den zweiten Schaltungsresonator 6 in Abhängigkeit von der Regelgröße U_{R} für den Referenzresonator 11 durch einen weiteren D/A-Wandler erzeugt.

Der zweite Schaltungsresonator 6 ist gegenüber dem Schaltungsresonator 5 leicht verstimmt, um eine Bandpassfunktion des Filters 4 zu gewährleisten. Für den Fall, dass der Schaltungsresonator 5 und der zweite Schaltungsresonator 6 identisch sind, wird dazu eine Regelgröße U_{S2} für den zweiten Schaltungsresonator 6 auf den zweiten Schaltungsresonator 6 angewandt, die von der Regelgröße U_{S1} für den Schaltungsresonator 5 abweicht, die auf den Schaltungsresonator 5 angewandt wird.

Für einfache Anwendungen ist es aber auch möglich, auf den Mikrokontroller 18 und die Wandler 17, 19 und 20 zu verzichten, indem die gleichen Regelgrößen U_{R}, U_{S2} und U_{S1} auf alle Resonatoren angewandt werden. Weiterhin ist es denkbar, dass die Regelgrößen U_{R}, U_{S1} und U_{S2}, zum Beispiel über einen Spannungsteiler, in ein gewünschtes, festes Verhältnis gesetzt werden.

Der Referenzresonator 11, der Schaltungsresonator 5 und der zweite Schaltungsresonator 6 sind auf dem gleichen Wafer 21 ausgeführt und werden durch diesen thermisch miteinander verbunden.

Durch die Regelgröße U_{S1} für den Schaltungsresonator 5 und die Regelgröße U_{S2} für den zweiten Schaltungsresonator 6 bzw. das Verhältnis dieser Regelgrößen zueinander kann die Bandbreite und/oder die Mittenfrequenz des Filters 4 eingestellt werden.

Der Mikrokontroller 18 kann die Regelgröße U_{S1} für den Schaltungsresonator 5 und die Regelgröße U_{S2} für den zweiten Schaltungsresonator 6 in Abhängigkeit der Regelgröße U_{R} für de Referenzresonator 11 über einen festen mathematischen Zusammenhang ermitteln. Es ist hier aber auch der Einsatz von neuronalen Netzen denkbar.

Ein mögliches Problem ist die Isolation zwischen dem Referenzresonator 11 und den Schaltungsresonatoren 5, 6 des Filters 4. Ein Übersprechen zwischen dem Oszillator 9 und dem Filter 4 lässt sich durch folgende Betriebsmodi der Regelung umgehen:
a) Falls der Oszillator 9 innerhalb der Nutzbandbreite des Filters 4 arbeitet, wird die Regelgröße U_{R} für den Referenzresonator 11 zeitlich versetzt zu den Zeitabschnitten ermittelt, in denen das Filter 4 aktiv ist. Handelt es sich bei der Resonatoranordnung 1 um eine Resonatoranordnung für ein Mobiltelefon, die als Filter im Empfangszweig eingesetzt wird, so lassen sich zum Beispiel die Sendefenster für den Betrieb der Oszillatorschaltung nutzen. Unter Ausnutzung der Kurzzeitstabilität der Resonatoranordnung 1 werden die Regelgrößen U_{S1} und U_{S2} für die Schaltungsresonatoren 5, 6 im Empfangsfenster gehalten und der Oszillator 9 wird während dieser Zeit abgeschaltet.
b) Der Oszillator 9 wird ständig außerhalb der Nutzbandbreite des Filters 4 betrieben. Bei bekannter Steigung der Abstimmkennlinien der Resonatoren können die aktuellen Regelgrößen U_{S1} und U_{S2} für die Schaltungsresonator für die Schaltungsresonator 5, 6 extrapoliert werden.
c) Der Oszillator 9 wird gleichzeitig als lokaler Oszillator (LO) für eine Sende-/Empfangsschaltung verwendet, in der der Schaltungsresonator 5 angeordnet ist. Gerade bei Direct-Conversion-Verfahren liegt die Arbeitsfrequenz des lokalen Oszillators nahe oder bei der Empfangsfrequenz (echtes Direct-Conversion bzw. Low-IF). Ein großer Vorteil bei diesem Betriebsmodus ist, dass keine zusätzlichen Bauteile benötigt werden. Die zusätzliche Steuerfunktionalität wird aus dem bereits vorhandenen Mikrokontroller 18 bezogen.

## Patentansprüche

1. Resonatoranordnung mit
- einem abstimmbaren Referenzresonator (11),
- Mitteln (13, 14) zum Abstimmen des Referenzresonators (11) mittels einer Regelgröße (U_{R}) für den Referenzresonator (11) auf einen Referenzwert,
- einem abstimmbaren Schaltungsresonator (5) und
- Mitteln (18, 19) zum Abstimmen des Schaltungsresonators (5), wobei die Mittel (18, 19) zum Abstimmen des Schaltungsresonators (5) so ausgebildet sind, dass die Regelgröße (U_{R}) für den Referenzresonator (11) als Maß für das Abstimmen des Schaltungsresonators (5) anwendbar ist,
**dadurch gekennzeichnet,**
**dass** der Referenzresonator (11) und der Schaltungsresonator (5) als Oberflächenwellenbauelemente, als Volumenwellenbauelemente oder als Membranschwinger ausgebildet sind und
**dass** der Referenzresonator (5) und der Schaltungsresonator (6) auf dem gleichen Wafer (21) angeordnet sind.

2. Resonatoranordnung nach Anspruch 1,
**dadurch gekennzeichnet, dass**
- der Referenzresonator (11) in einer Oszillatorschaltung (9, 11) angeordnet ist,
- die Resonatoranordnung (1) Mittel (13) zum Vergleichen der Oszillatorschaltungsfrequenz mit einer Referenzfrequenz aufweist und
- die Mittel (13, 14) zum Abstimmen des Referenzresonators (11) mittels der Regelgröße (U_{R}) für den Referenzresonator (11) so ausgebildet sind, dass durch das Abstimmen des Referenzresonators (11) die Oszillatorschaltungsfrequenz auf die Referenzfrequenz einstellbar ist.

3. Anordnung mit einer Resonatoranordnung nach einem der vorhergehenden Ansprüche und einem Filter,
**dadurch gekennzeichnet,**
**dass** der Schaltungsresonator (5) in dem Filter (4) angeordnet ist.

4. Resonatoranordnung nach einem der vorhergehenden Ansprüche,
**dadurch gekennzeichnet,**
**dass** die Resonatoranordnung mindestens einen zweiten abstimmbaren Schaltungsresonator (6) aufweist.

5. Resonatoranordnung nach Anspruch 4,
**dadurch gekennzeichnet,**
**dass** die Schaltungsresonatoren (5, 6) gegeneinander verstimmt sind.

6. Anordnung nach Anspuch 3 mit einer Resonatoranordnung nach den Anspruch 4,
**dadurch gekennzeichnet,**
**dass** die Schaltungsresonatoren (5, 6) in einem Laddertypefilter (4) angeordnet sind.

7. Resonatoranordnung nach einem der vorhergehenden Ansprüche,
**dadurch gekennzeichnet,**
**dass** die Resonatoranordnung (1) Mittel (21) zur thermischen Kopplung des Referenzresonators und des Schaltungsresonators aufweist.

8. Resonatoranordnung nach Anspruch 2,
**dadurch gekennzeichnet,**
**dass** die Oszillatorschaltung (9, 11) zeitlich diskontinuierlich betreibbar ist.

9. Sende- und/oder Empfangsanordnung mit einer Sende- und/oder Empfangsschaltung und einer Resonatoranordnung nach einem der vorhergehenden Ansprüche,
**dadurch gekennzeichnet,**
**dass** der Schaltungsresonator (5) in der Sende- und/oder Empfangsschaltung angeordnet ist.

10. Resonatoranordnung nach Anspruch 8,
**dadurch gekennzeichnet,**
**dass** die Oszillatorschaltung (9,11) abschaltbar ist, sobald die eine Sende- und/oder Empfangsschaltung sendet und/oder empfängt.

11. Resonatoranordnung nach Anspruch 3,
**dadurch gekennzeichnet,**
**dass** die Oszillatorschaltungsfrequenz außerhalb der Nutzbandbreite des Filters (4) liegt.

12. Resonatoranordnung nach Anspruch 2,
**dadurch gekennzeichnet,**
**dass** die Resonatoranordnung Einstellmittel zum Einstellen eines Schaltungsfrequenzsignals aufweist, das mit dem Ausgangssignal der Filterschaltung gemischt wird, und dass die Einstellmittel so ausgebildet sind, dass durch die Einstellmittel auch die Oszillatorschaltungsfrequenz einstellbar ist.

13. Resonatoranordnung nach Anspruch 2,
**dadurch gekennzeichnet,**
**dass** die Oszillatorschaltung (9,11) einen Oszillator (9) aufweist, der so eingerichtet ist, dass er auch als Oszillator (9) für eine Schaltung dient, in der das Schaltungsfrequenzsignal erzeugt wird.

14. Verfahren zur Resonatorabstimmung, bei dem
- ein abstimmbarer Referenzresonator (11) mittels einer Regelgröße (U_{R}) für den Referenzresonator (11) auf einen Referenzwert abgestimmt wird und
- die Regelgröße (U_{R}) für den Referenzresonator (11) als Maß für die Abstimmung mindestens eines abstimmbaren Schaltungsresonators (6) angewandt wird,
**dadurch gekennzeichnet,**
**dass** der Referenzresonator (11) und/oder der Schaltungsresonator (5) als Oberflächenwellenbauelemente, als Volumenwellenbauelemente oder als Membranschwinger ausgebildet sind und
**dass** der Referenzresonator (5) und der Schaltungsresonator (6) vom gleichen Wafer (21) stammen.

## Claims

1. A resonator arrangement having
- a tunable reference resonator (11),
- means (13, 14) for tuning the reference resonator (11) to a reference value by means of a controlled variable (U_{R}) for the reference resonator (11),
- a tunable circuit resonator (5), and
- means (18, 19) for tuning the circuit resonator (5), the means (18, 19) for tuning the circuit resonator (5) being designed in such a way that the controlled variable (U_{R}) for the reference resonator (11) can be used as a measure of the tuning of the circuit resonator (5),
**characterized**
**in that** the reference resonator (11) and the circuit resonator (5) are designed as surface acoustic wave components, as bulk acoustic wave components or as diaphragm oscillators and in that the reference resonator (5) and the circuit resonator (6) are arranged on the same wafer (21).

2. Resonator arrangement according to Claim 1,
**characterized in that**
- the reference resonator (11) is arranged in an oscillator circuit (9, 11),
- Resonator arrangement (1) has means (13) for comparing the oscillator circuit frequency with a reference frequency, and
- the means (13, 14) for tuning the reference resonator (11) by means of the controlled variable (U_{R}) for the reference resonator (11) are designed in such a way that, through the tuning of the reference resonator (11), the oscillator circuit frequency can be set to the reference frequency.

3. Arrangement having a resonator arrangement according to one of the preceding claims and a filter,
**characterized**
**in that** the circuit resonator (5) is arranged in the filter (4).

4. Resonator arrangement according to one of the preceding claims,
**characterized**
**in that** Resonator arrangement has at least one second tunable circuit resonator (6).

5. Resonator arrangement according to at least claim 4,
**characterized**
**in that** the circuit resonators (5, 6) are detuned with respect to one another.

6. Arrangement according to Claim 3 having a resonator according to Claim 4,
**characterized**
**in that** the circuit resonators (5, 6) are arranged in a ladder-type filter (4).

7. Resonator arrangement according to one of the preceding claims,
**characterized**
**in that** Resonator arrangement (1) has means (21) for thermally coupling the reference resonator and the circuit resonator.

8. Resonator arrangement according to Claim 2,
**characterized**
**in that** the oscillator circuit (9, 11) can be operated temporally discontinuously.

9. Transmitting and/or receiving arrangement having a transmitting and/or receiving circuit and a resonator arrangement according to one of the preceding claims,
**characterized**
**in that** the circuit resonator (5) is arranged in the transmitting and/or receiving circuit.

10. Resonator arrangement according to Claim 8,
**characterized**
**in that** the oscillator circuit (9, 11) can be switched off as soon as one transmitting and/or receiving circuit transmits and/or receives.

11. Resonator arrangement according to Claim 3,
**characterized**
**in that** the oscillator circuit frequency lies outside the useful bandwidth of the filter (4).

12. Resonator arrangement according to Claim 2,
**characterized**
**in that** Resonator arrangement has setting means for setting a circuit frequency signal which is mixed with the output signal of the filter circuit, and in that the setting means are designed in such a way that the oscillator circuit frequency can also be set by the setting means.

13. Resonator arrangement according to Claim 2,
**characterized**
**in that** the oscillator circuit (9, 11) has an oscillator (9) which is set up in such a way that it also serves as an oscillator (9) for a circuit in which the circuit frequency signal is generated.

14. Method for resonator tuning, in which
- a tunable reference resonator (11) is tuned to a reference value by means of a controlled variable (U_{R}) for the reference resonator (11), and
- the controlled variable (U_{R}) for the reference resonator (11) is used as a measure of the tuning of at least one tunable circuit resonator (6),
**characterized**
**in that** the reference resonator (11) and/or the circuit resonator (5) are designed as surface acoustic wave components, as bulk acoustic wave component or as diaphragm oscillators and in that the reference resonator (5) and the circuit resonator (6) originate from the same wafer (21).

## Revendications

1. Système de résonateurs, comprenant
- un résonateur de référence accordable (11),
- des moyens (13, 14) pour accorder le résonateur de référence (11) sur une valeur de référence à l'aide d'une grandeur de réglage (U_{R}) pour le résonateur de référence (11),
- un résonateur de circuit accordable (5) et
- des moyens (18, 19) pour accorder le résonateur de circuit (5), les moyens (18, 19) pour accorder le résonateur de circuit (5) étant exécutés de manière à ce que la grandeur de réglage (U_{R}) pour le résonateur de référence (11) puisse être utilisée en tant que grandeur pour accorder le résonateur de circuit (5),
**caractérisé en ce que**
le résonateur de référence (11) et le résonateur de circuit (5) sont exécutés en tant que composants à ondes de surface, en tant que composants à ondes de volume ou en tant qu'oscillateurs à membrane et
**en ce que** le résonateur de référence (5) et le résonateur de circuit (6) sont situés sur la même tranche (21).

2. Système de résonateurs selon la revendication 1,
**caractérisé en ce que**
- le résonateur de référence (11) est situé dans un circuit oscillateur (9, 11),
- le système de résonateurs (1) est pourvu de moyens (13) pour comparer la fréquence de circuit oscillateur avec une fréquence de référence et
- les moyens (13, 14) pour accorder le résonateur de référence (11) à l'aide de la grandeur de réglage (U_{R}) pour le résonateur de référence (11) sont exécutés de manière à pouvoir régler la fréquence de circuit oscillateur sur la fréquence de référence en accordant le résonateur de référence (11).

3. Dispositif comprenant un système de résonateurs selon l'une des revendications précédentes et un filtre,
**caractérisé en ce que**
le résonateur de circuit (5) est situé dans le filtre (4).

4. Système de résonateurs selon l'une des revendications précédentes,
**caractérisé en ce que**
le système de résonateurs comprend au moins un second résonateur de circuit accordable (6).

5. Système de résonateurs selon la revendication 4,
**caractérisé en ce que**
les résonateurs de circuit (5, 6) sont désaccordés l'un par rapport à l'autre.

6. Dispositif selon la revendication 3, comprenant un système de résonateurs selon la revendication 4,
**caractérisé en ce que**
les résonateurs de circuit (5, 6) sont situés dans un filtre de type échelle (4).

7. Système de résonateurs selon l'une des revendications précédentes,
**caractérisé en ce que**
le système de résonateurs (1) est pourvu de moyens (21) pour le couplage thermique du résonateur de référence et du résonateur de circuit.

8. Système de résonateurs selon la revendication 2,
**caractérisé en ce que**
on peut faire fonctionner le circuit oscillateur (9, 11) de manière discontinue dans le temps.

9. Dispositif émetteur et/ou récepteur comprenant un circuit émetteur et/ou récepteur et un système de résonateurs selon l'une des revendications précédentes,
**caractérisé en ce que**
le résonateur de circuit (5) est situé dans le circuit émetteur et/ou récepteur.

10. Système de résonateurs selon la revendication 8,
**caractérisé en ce que**
le circuit oscillateur (9, 11) peut être mis hors tension dès que le circuit émetteur et/ou récepteur émet et/ou reçoit.

11. Système de résonateurs selon la revendication 3,
**caractérisé en ce que**
la fréquence de circuit oscillateur se trouve en dehors de la bande passante utile du filtre (4).

12. Système de résonateurs selon la revendication 2,
**caractérisé en ce que**
le système de résonateurs est pourvu de moyens de réglage pour régler un signal de fréquence de circuit qui est mélangé avec le signal de sortie du circuit de filtrage, et **en ce que** les moyens de réglage sont exécutés de manière à ce que la fréquence de circuit oscillateur puisse elle aussi être réglée par les moyens de réglage.

13. Système de résonateurs selon la revendication 2,
**caractérisé en ce que**
le circuit oscillateur (9, 11) comprend un oscillateur (9) qui est adapté pour servir également d'oscillateur (9) pour un circuit dans lequel le signal de fréquence de circuit est produit.

14. Procédé pour accorder des résonateurs, dans lequel
- un résonateur de référence accordable (11) est accordé sur une valeur de référence à l'aide d'une grandeur de réglage (U_{R}) pour le résonateur de référence (11) et
- la grandeur de réglage (U_{R}) pour le résonateur de référence (11) est appliquée en tant que grandeur pour accorder au moins un résonateur de circuit accordable (6),
**caractérisé en ce que**
le résonateur de référence (11) et/ou le résonateur de circuit (5) est/sont exécuté/s en tant que composants à ondes de surface, en tant que composants à ondes de volume ou en tant qu'oscillateurs à membrane et
**en ce que** le résonateur de référence (5) et le résonateur de circuit (6) proviennent de la même tranche (21).
